# EUROPEAN PATENT SPECIFICATION

(11) **EP 2 453 728 B1**
(45) Date of publication and mention of the grant of the patent: **03.07.2013**
(21) Application number: 10014580.4
(22) Date of filing: 13.11.2010
(51) Int. Cl.: H05K 7/20

(54) **Fan holder and fan holder module**
Lüfterhalterung und Lüfterhalterungsmodul
Support de ventilateur et module de support du ventilateur

(43) Date of publication of application: 16.05.2012
(73) Proprietor: Giga-Byte Technology Co., Ltd., Taipei-Hsien 231 (TW)
(72) Inventor: Lu, Tong-Ke, Hsin-Tien Taipei Hsien 231 (TW)
(74) Representative: Schwerbrock, Florian

(56) References cited:
- US-A1- 2004 033 139
- US-A1- 2007 009 356
- US-A1- 2008 253 886

## Description

### BACKGROUND OF THE INVENTION

### Field of the Invention

The invention relates to a fan holder module, particularly a holder that can be applied to fans of different specifications, and the fan holder module that uses the holder.

### Description of Related Art

The way conventional fans are fixed to a holder within the system, which requires screw material and manual labor, affecting the manufacture cost of the product.

An example of such a conventional fan is disclosed by the document US2004033139, HON HAI PREC IND CO LTD, (GAN LI YUAN, ZHANG GUANG, LI LU SHENG), published on 19-02-2004.

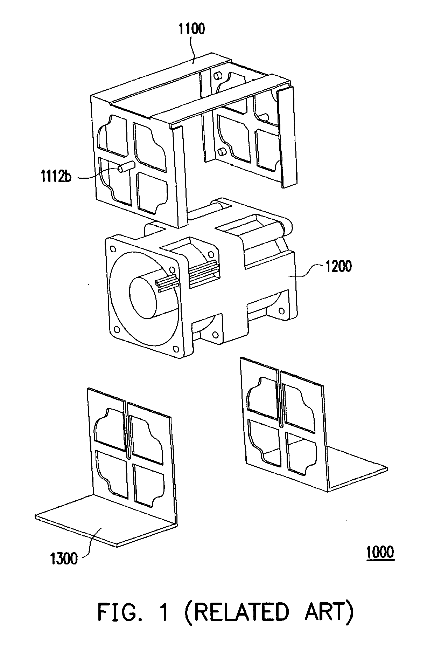

In order to solve the mentioned problem, the applicant addresses a fan module 1000 shown in Fig. 1, where a holder 1100 is disposed between a bracket 1300 and a fan 1200. The fan 1200 is fixed within the holder 1100 by locking mechanism and the resilience of the holder, and the holder 1100 is assembled onto the bracket 1300 by a shaft 1112b. The assembly process of the fan module 1000 does not require screws, and not only reduces manual labor, but also reduces production cost.

Nevertheless, since current fans have a variety of specifications, the holder dimensions need to be correspondingly molded when directed to fans of different specifications. Thus, the manufacturing cost respectively increases.

### SUMMARY OF THE INVENTION

The invention provides a fan holder module that applies to fans of different specifications.

The invention provides a holder assembly different from conventional holder assemblies.

The invention provides a fan holder module, wherein the fan holder module comprises a first fan holder and a second fan holder. The first fan holder includes a first body, a first connecting portion and a second connecting portion. The first connecting portion and the second connecting portion are disposed at opposite sides of the first body and are parallel to each other. The second fan holder includes a second body, a third connecting portion and a fourth connecting portion. The third connecting portion and the fourth connecting portion are disposed at opposite sides of the second body and are parallel to each other. The first connecting portion is fixed with the third connecting portion, and the second connecting portion is fixed with the fourth connecting portion.

In the fan holder module of the present invention, the first connecting portion and the fourth connecting portion may be respectively a protruded strip. The second connecting portion and the third connecting portion may be respectively a sliding track. The protruded strips are slidably disposed on the sliding tracks, and the locations of the protruded strips to the sliding tracks determine the distance between the first body and the second body. In addition, the fan holder module may further comprise a plurality of fixing pieces. Each protruded strip may include a fixing hole, and each sliding track may include an opening trough, wherein the fixing pieces correspondingly pass through the opening troughs and correspondingly lock into the plurality of fixing holes. Furthermore, each of the protruding strips includes a plurality of openings, and an end of each sliding track includes a locking hook, and each of the locking hooks is fastened to the corresponding opening of the protruding strips.

In the fan holder module of the present invention, the first connecting portion and the second connecting portion may respectively be a protruded strip. The third connecting portion and the fourth connecting portion may respectively be a sliding track. The plurality of protruded strips can slidably be disposed on the plurality of sliding tracks, and the locations of the protruded strips to the sliding tracks determine the distance between the first body and the second body. The fan holder module may further comprise a plurality of fixing pieces. Each protruded strip may include a fixing hole, and each sliding track may include an opening trough, wherein the fixing pieces correspondingly pass through the corresponding opening troughs, and correspondingly locks into the fixing holes. Furthermore, each of the protruding strips may include a plurality of openings, and the outward end of each sliding track includes a locking hook, and each of the locking hooks can correspondingly be fastened to one of the openings of the plurality of protruding strips.

The invention further provides a fan holder, which comprises a first body, a first connecting portion and a second connecting portion, wherein the first connecting portion and the second connecting portion are disposed at opposite sides of the first body and are parallel to each other. The two related fan holders are suitable to be assembled to each other, which allows both first connecting portions of the two fan holders to respectively connect with the second connecting portion of the other fan holder.

According to the present invention, the first connecting portion may be a protruding strip, and the second connecting portion may be a sliding track. In addition, the protruding strip may include a plurality of openings, and an end of the sliding track may comprise a locking hook. Furthermore, the protruding strip may include a fixing hole, and the sliding track comprises an opening trough.

According to the present invention, the structure of the first connecting portion may be same to the structure of the second connecting portion.

Based on the above, referring to the holder and the fan holder module that uses the holder of the invention, the distance between the bodies of the holder can change, and contain fans of different specifications.

In order to make the aforementioned and other features and advantages of the invention more comprehensible, embodiments accompanying figures are described in detail below.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the disclosure.

Fig. 1 is a schematic diagram of a conventional fan module.

Fig. 2 is a schematic diagram of a fan module of the first embodiment of the invention.

Fig. 3 is a schematic diagram of a first fan holder.

Fig. 4 is a schematic diagram of a second fan holder.

Fig. 5 is a schematic diagram of a first fan holder of the second embodiment of the invention.

Fig. 6 is a schematic diagram of a second fan holder of the second embodiment of the invention.

Fig. 7 is a schematic diagram of a fan holder of the third embodiment of the invention.

Fig. 8 is a schematic diagram of a fan holder of the fourth embodiment of the invention.

Fig. 9 is a schematic diagram of a fan holder of the fifth embodiment of the invention.

### DESCRIPTION OF EMBODIMENTS

In order to solve the problem that conventional holders required to correspondingly adjust its specifications when directed to fans of different specifications, the invention provides a common use holder concept, where the holder length can change, and is interchangeable to fans of different specifications, so as to achieve the goal of reduction in used materials and saving the production cost.

### [FIRST EMBODIMENT]

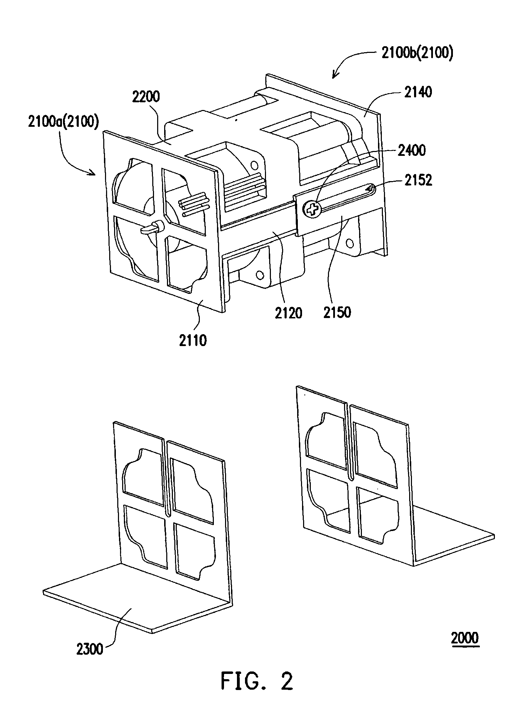

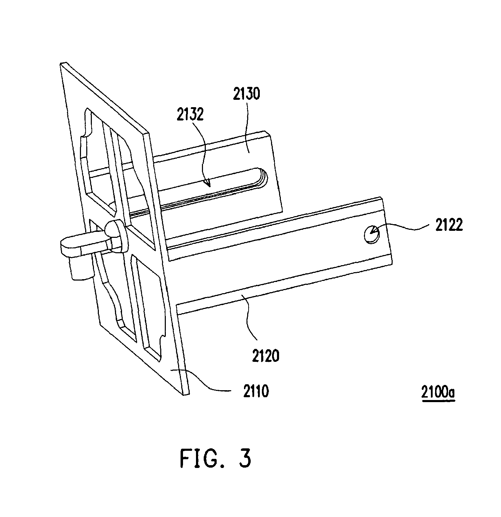

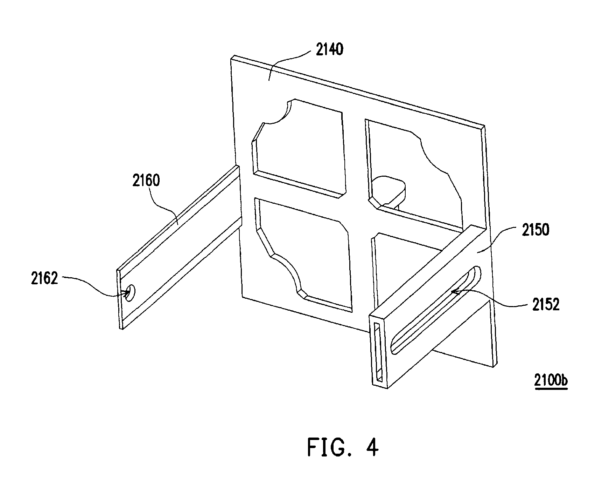

Fig. 2 is a schematic diagram of a fan module of the first embodiment of the invention, Fig. 3 is a schematic diagram of a first fan holder, and Fig. 4 is a schematic diagram of a second fan holder. Please refer to Fig. 2, Fig. 3, and Fig. 4. A fan holder module 2000 of the embodiment comprises two fan holders 2100, a fan 2200, and two brackets 2300. For the sake of simplicity, a first fan holder 2100a and a second fan holder 2100b are viewed and described separately in the figures and the specification. In detail, the first fan holder 2100a comprises a first body 2110, a first connecting portion 2120 and a second connecting portion 2130, wherein the first connecting portion 2120 and the second connecting portion 2130 are disposed at opposite sides of the first body 2110 and are parallel to each other. The second fan holder 2100b comprises a second body 2140, a third connecting portion 2150 and a fourth connecting portion 2160, wherein the third connecting portion 2150 and the fourth connecting portion 2160 are disposed at opposite sides of the second body 2140 and are parallel to each other.

In the present embodiment, the first connecting portion 2120 and the fourth connecting portion 2160 are respectively a protruded strip. The second connecting portion 2130 and the third connecting portion 2150 are respectively a sliding track. The protruded strips are inserted in the sliding tracks, and the locations of the protruded strips to the sliding tracks determine the clamping distance of the fan 2200 between the first body 2110 and the second body 2140. According to the above, the first connecting portion 2120 (protruding strip) is inserted into the third connecting portion 2150 (sliding track), and the fourth connecting portion 2160 (protruding strip) is inserted into the second connecting portion 2130 (sliding track). The protruding strip moves within the sliding track and changes the distance between the first body 2110 and the second body 2140, and so applies to fans 2200 of different specifications.

In addition, the free end of the first connecting portion 2120 comprises a fixing hole 2122, and the free end of the fourth connecting portion 2160 comprises a fixing hole 2162. The second connecting portion 2130 comprises an opening trough 2132, and the third connecting portion 2150 comprises an opening trough 2152. The fan holder module 2000 may further comprise a plurality of fixing pieces 2400. The fixing pieces 2400 pass through the opening trough 2152 or the opening trough 2132 and correspondingly lock into the fixing hole 2122 or the fixing hole 2162, thereby applying pressure to fix the distance between the first body 2110 and the second body 2140.

### [SECOND EMBODIMENT]

The embodiment is similar to the first embodiment, and same or similar reference numerals used in the embodiment and in the first embodiment represent the same or similar elements. The following only directs to the differences for further explanation.

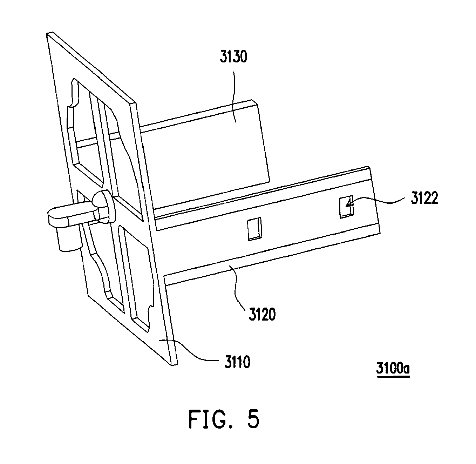

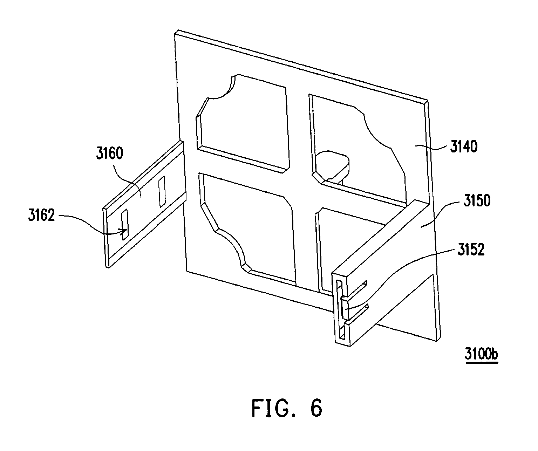

Fig. 5 is a schematic diagram of a first fan holder of the second embodiment of the invention, and Fig. 6 is a schematic diagram of a second fan holder of the second embodiment of the invention. Please refer to Fig 5 and Fig. 6. A first connecting portion 3120 of a first fan holder 3100a comprises a plurality of openings 3122. A fourth connecting portion 3160 of a second fan holder 3100b comprises a plurality of openings 3162. The end of a second connecting portion 3130 of the first fan holder 3100a comprises a locking hook (not shown), the end of a third connecting portion 3150 of the second fan holder 3100b comprises a locking hook 3152. When the first connecting portion 3120 of the first fan holder 3100a is inserted into the third connecting portion 3150 of the second fan holder 3100b, and when the fourth connecting portion 3160 of the second fan holder 3100b is inserted in the second connecting portion 3130 of the first fan holder 3100a, the locking hook (not shown) of the second connecting portion 3130 and the locking hook 3152 of the third connecting portion 3150 correspondingly locks into the opening 3162 and the opening 3122. The locking hook (not shown) of the second connecting portion 3130 and the locking hook 3152 of the third connecting portion 3150 can appropriately lock into one opening 3122 of the first connecting portion 3120 and one opening 3162 of the fourth connecting portion 3160 according to the specification of the fan 2200 (as shown in Fig. 2), and the distance between the first body 3110 and the second body 3140 is changed.

### [THIRD EMBODIMENT]

The embodiment is similar to the above embodiment, and same or similar reference numerals used in the embodiment and in the above embodiment represent the same or similar elements. The following only directs to the differences for further explanation.

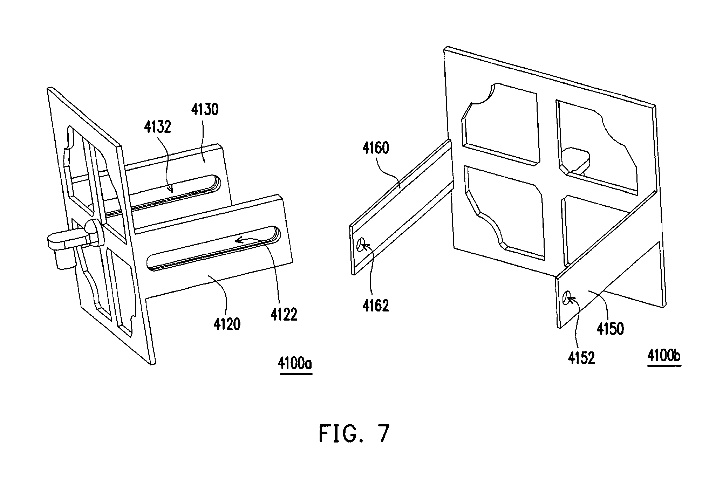

Fig. 7 is a schematic diagram of a fan holder of the third embodiment of the invention. Please refer to Fig. 7. In the present embodiment, a third connecting portion 4120 of a second fan holder 4100a comprises an opening trough 4122, and a fourth connecting portion 4130 comprises an opening trough 4132, and the disposed locations, trough lengths and trough widths of the two opening troughs 4122, 4132 correspond to each other. In addition, the free end of the first connecting portion 4150 of the first fan holder 4100b comprises a fixing hole 4152, and the free end of the second connecting portion 4160 comprises a fixing hole 4162. In other words, the structure of the third connecting portion 4120 and the structure of the fourth connecting portion 4130 are similar. Also, the structure of the first connecting portion 4150 and the structure of the second connecting portion 4160 are similar.

### [FOURTH EMBODIMENT]

The embodiment is similar to the above embodiment, and same or similar reference numerals used in the embodiment and in the above embodiment represent the same or similar elements. The following only directs to the differences for further explanation.

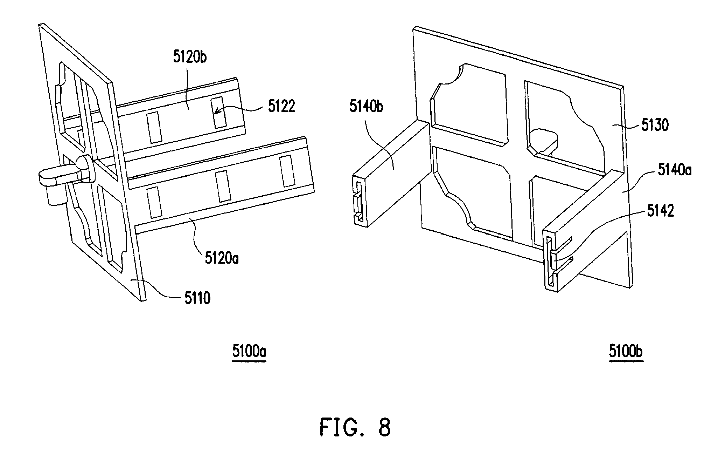

Fig. 8 is a schematic diagram of a fan holder of the fourth embodiment of the invention. Please refer to Fig. 8. In the fourth embodiment, a first connecting portion 5120a and a second connecting portion 5120b of a first fan holder 5100a have the same structures, and a third connecting portion 5140a and a fourth connecting portion 5140b of a second fan holder 5100b also have the same structures. However, the structure of the first connecting portion 5120a and the structure of the third connecting portion 5140a are different.

In detail, the first connecting portion 5120a and the second connecting portion 5120b of the first fan holder 5100a are protruding strips, and are disposed at opposite sides of a first body 5110 and are parallel to each other. The third connecting portion 5140a and the fourth connecting portion 5140b of the second fan holder 5100b are slide tracks, and are disposed at opposite sides of a second body 5130 and are parallel to each other. The first connecting portion 5120a and the second connecting portion 5120b comprise of a plurality of openings 5122. The free end of the third connecting portion 5140a and the fourth connecting portion 5140b respectively comprise a locking hook 5142. The first connecting portion 5120a and the second connecting portion 5120b (protruding strips) are correspondingly inserted into the third connecting portion 5140a and the fourth connecting portion 5140b (slide tracks), and the locking hook 5142 is correspondingly locked into the opening 5122.

### [FIFTH EMBODIMENT]

The embodiment is similar to the above embodiment, and same or similar reference numerals used in the embodiment and in the above embodiment represent the same or similar elements. The following only directs to the differences for further explanation.

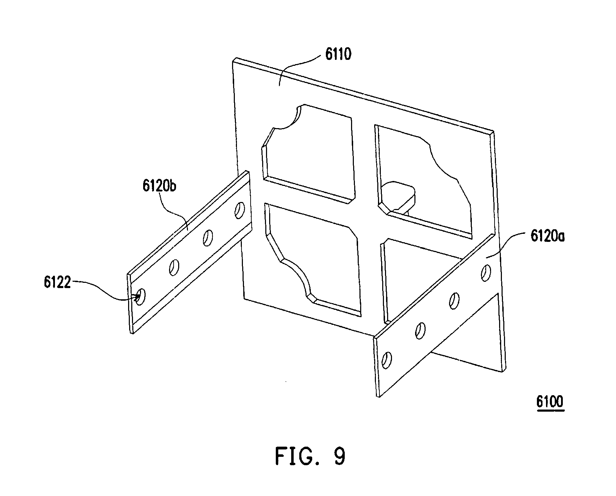

Fig. 9 is a schematic diagram of a fan holder of the fifth embodiment of the invention. Please refer to Fig. 9. In the present embodiment, a first connecting portion 6120a and a second connecting portion 6120b of a fan holder 6100 have similar structures, and are protruding strips. Each protruding strip includes a plurality of fixing holes 6122. It should be noted that the two similar fan holders 6100 are assembled to form a fan holder module by using screws (not shown) locking into the fixing hole 6122 correspondingly. The distance between the two bodies 6110 of the two fan holders 6100 can be adjusted and changed according to the corresponding fixing hole 6122 the screw is locked into.

The aforementioned embodiments serve only as examples. People skilled in the art can adjust the holder structure according to actual requirements. For example the locking hook, fixing hole, and sliding trough designs only need to achieve the ability to change the corresponding position between the connecting portions, and allow the distance between the two bodies to correspondingly adjust to fans of different specifications.

To sum up, the fan holder and fan holder module of the invention are interchangeable to fans of different specifications. Fans of different specifications no longer require corresponding holders of different specifications. This effectively reduces the use materials and achieves the goal of saving production cost.

## Claims

1. A fan holder module (2000) for holding a fan (2200), the fan holder module (2000) **characterized by** comprising:
a first fan holder (2100a, 3100a), comprising a first body (2110, 3110), a first connecting portion (2120, 3120) and a second connecting portion (2130, 3130), the first connecting portion (2120, 3120) and the second connecting portion (2130, 3130) disposed at opposite sides of the first body (2110, 3110) and being parallel to each other; and
a second fan holder (2100b, 3100b), comprising a second body (2140, 3140), a third connecting portion (2150, 3150) and a fourth connecting portion (2160, 3160), the third connecting portion (2150, 3150) and the fourth connecting portion (2160, 3160) disposed at opposite sides of the second body (2140, 3140) and being parallel to each other,
wherein the first connecting portion (2120, 3120) and the third connecting portion (2150, 3150) are connected, the second connecting portion (2130, 3130) and the fourth connecting portion (2160, 3160) are connected, and the fan (2200) is held between the first connecting portion (2120, 3120), the second connecting portion (2130, 3130), the third connecting portion (2150, 3150), and the fourth connecting portion (2160, 3160), wherein the first connecting portion (2120, 3120) and the fourth connecting portion (2160, 3160) are respectively a protruded strip, the second connecting portion (2130, 3130) and the third connecting portion (2150, 3150) are respectively a sliding track, the protruded strips are slidably disposed on the sliding tracks correspondingly, and the locations of the protruded strips to the sliding tracks determine the distance between the first body (2110, 3110) and the second body (2140, 3140).

2. The fan holder module (2000) of claim 1, further comprising a plurality of fixing pieces (2400), and each protruded strip defines a fixing hole (2122, 2162), and each sliding track defines an opening trough (2132, 2152), wherein the fixing pieces (2400) respectively pass through the opening troughs (2132, 2152) and correspondingly lock into the fixing holes (2122, 2162).

3. The fan holder module (2000) of claim 1, wherein a plurality of openings (3122, 3162) are formed on each of the protruded strips, and an end of each of sliding tracks includes a locking hook (3152), and each of the locking hooks (3152) is correspondingly fastened to one of the openings (3122, 3162) of the protruded strips.

4. A fan holder module (2000) for holding a fan (2200), the fan holder module (2000) **characterized by** comprising:
a first fan holder (4100b, 5100a), comprising a first body (5110), a first connecting portion (4150, 5120a) and a second connecting portion (4160, 5120b), the first connecting portion (4150, 5120a) and the second connecting portion (4160, 5120b) disposed at opposite sides of the first body (5110) and being parallel to each other; and
a second fan holder (4100a, 5100b), comprising a second body (5130), a third connecting portion (4120, 5140a) and a fourth connecting portion (4130, 5140b), the third connecting portion (4120, 5140a) and the fourth connecting portion (4130, 5140b) disposed at opposite sides of the second body (5130) and being parallel to each other,
wherein the first connecting portion (4150, 5120a) and the third connecting portion (4120, 5140a) are connected, the second connecting portion (4160, 5120b) and the fourth connecting portion (4130, 5140b) are connected, and the fan (2200) is held between the first connecting portion (4150, 5120a), the second connecting portion (4160, 5120b), the third connecting portion (4120, 5140a), and the fourth connecting portion (4130, 5140b), wherein the first connecting portion (4150, 5120a) and the second connecting portion (4160, 5120b) are respectively a protruded strip, and the third connecting portion (4120, 5140a) and the fourth connecting portion (4130, 5140b) are respectively a sliding track, and the protruded strips are inserted in the sliding tracks correspondingly, and the locations of the protruded strips to the sliding tracks determine the distance between the first body and the second body.

5. The fan holder module (2000) of claim 4, further comprising a plurality of fixing pieces (2400) and a fixing hole (4152, 4162) formed on each of the protruded strips, wherein each sliding track defines an opening trough (4122, 4132), and the fixing pieces (2400) respectively pass through the opening troughs (4122, 4132) and are correspondingly locked into the fixing holes (4152, 4162).

6. The fan holder module (2000) of claim 4, wherein each of the protruded strips defines a plurality of openings (5122), and an end of each sliding track includes a locking hook (5142), and each of the locking hooks (5142) is correspondingly fastened to the plurality of the opening (5122) of the plurality of the protruded strips.

## Patentansprüche

1. Ein Ventilator-Haltemodul (2000) zum Halten eines Ventilators (2200), wobei das Ventilator-Haltemodul (2000) durch Folgendes gekennzeichnet ist:
einen ersten Ventilator-Halter (2100a, 3100a), umfassend einen ersten Körper (2110, 3110), einen ersten Verbindungsabschnitt (2120, 3120) und einen zweiten Verbindungsabschnitt (2130, 3130), wobei der erste Verbindungsabschnitt (2120, 3120) und der zweite Verbindungsabschnitt (2130, 3130) auf gegenüberliegenden Seiten des ersten Körpers angeordnet sind (2110, 3110) und dabei parallel zueinander stehen, und
einen zweiten Ventilator-Halter (2100b, 3100b), umfassend einen zweiten Körper (2140, 3140), einen dritten Verbindungsabschnitt (2150, 3150) und einen vierten Verbindungsabschnitt (2150, 3150), wobei der dritte Verbindungsabschnitt (2150, 3150) und der vierte Verbindungsabschnitt (2160, 3160) auf gegenüberliegenden Seiten des zweiten Körpers angeordnet sind (2140, 3140) und dabei parallel zueinander stehen,
wobei der erste Verbindungsabschnitt (2120, 3120) und der dritte Verbindungsabschnitt (2150, 3150) verbunden sind; der zweite Verbindungsabschnitt (2130, 3130) und der vierte Verbindungsabschnitt (2160, 3160) verbunden sind, und der Ventilator (2200) zwischen dem ersten Verbindungsabschnitt (2120, 3120), dem zweiten Verbindungsabschnitt (2130, 3130), dem dritten Verbindungsabschnitt (2150, 3150) und dem vierten Verbindungsabschnitt (2160, 3160) gehalten wird; wobei der erste Verbindungsabschnitt (2120, 3120) und der vierte Verbindungsabschnitt (2160, 3160) jeweils einen vorstehenden Steg aufweisen, wobei der zweite Verbindungsabschnitt (2130, 3130) und der dritte Verbindungsabschnitt (2150, 3150) jeweils eine Laufschiene aufweisen; und wobei die vorstehenden Stege entsprechend verschiebbar auf den Gleitschienen angeordnet sind, und die Positionen der vorstehenden Stege relativ zu den Gleitschienen den Abstand zwischen dem ersten Körper (2110, 3110) und dem zweiten Körper (2140, 3140) bestimmen die Distanz.

2. Das Ventilator-Haltemodul (2000) nach Anspruch 1, ferner umfassend eine Mehrzahl von Befestigungsteilen (2400), und jeder vorspringender Steg definiert ein Befestigungsloch (2122 2162), und jede Gleitschiene definiert eine Öffnungsrinne (2132, 2152), wobei die Befestigungsteile (2400) jeweils durch die Öffnungsrinnen (2132 2152) hindurchgehen und entsprechend in die Befestigungslöcher (2122, 2162) einrasten.

3. The fan holder module (2000) of claim 1, wherein a plurality of openings (3122, 3162) are formed on each of the protruded strips, and an end of each of sliding tracks includes a locking hook (3152), and each of the locking hooks (3152) is correspondingly fastened to one of the openings (3122, 3162) of the protruded strips.Das Ventilator-Haltemodul (2000) nach Anspruch 1, wobei eine Vielzahl von Öffnungen (3122, 3162) auf jedem der vorspringenden Stege ausgebildet ist, und ein Ende jeder der Gleitschienen einen Verriegelungshaken (3152) beinhaltet, und jeder der Verriegelungshaken (3152) entsprechend an einer Öffnungen (3122, 3162) der vorspringenden Stege befestigt ist.

4. A fan holder module (2000) for holding a fan (2200), the fan holder module (2000) **characterized by** comprising:Ein Ventilator-Haltemodul (2000) zum Halten eines Ventilators (2200), wobei das Ventilator-Haltemodul (2000) durch Folgendes gekennzeichnet ist:
einen ersten Ventilator-Halter (4100b, 5100a), umfassend einen ersten Körper (5110), einen ersten Verbindungsabschnitt (4150, 5120a) und einen zweiten Verbindungsabschnitt (4160, 5120b), wobei der erste Verbindungsabschnitt (4150, 5129a) und der zweite Verbindungsabschnitt (4160, 5120b) auf gegenüberliegenden Seiten des ersten Körpersd (5110) angeordnet sind und dabei parallel zueinander stehen, und
einen zweiten Ventilator-Halter (4100a, 5100b), umfassend einen zweiten Körper (5130), einen dritten Verbindungsabschnitt (4120, 5140a) und einen vierten Verbindungsabschnitt (4130, 5140b), wobei der dritte Verbindungsabschnitt (4120, 5140a) und der vierte Verbindungsabschnitt (4130, 5140b) auf gegenüberliegenden Seiten des zweiten Körpers (5130) angeordnet sind und dabei parallel zueinander stehen,
wobei der erste Verbindungsabschnitt (4150, 5120a) und der dritte Verbindungsabschnitt (4120, 3150) verbunden sind; der zweite Verbindungsabschnitt (4160, 5120b) und der vierte Verbindungsabschnitt (4130, 5140b) verbunden sind, und der Ventilator (2200) zwischen dem ersten Verbindungsabschnitt (4150, 5120a), dem zweiten Verbindungsabschnitt (4160, 5120b), dem dritten Verbindungsabschnitt (4120, 5140a) und dem vierten Verbindungsabschnitt (4130, 5140b) gehalten wird; wobei der erste Verbindungsabschnitt (4150, 5120a) und der zweite Verbindungsabschnitt (4160, 5120b) jeweils aus einem vorstehenden Steg bestehen, wobei der dritte Verbindungsabschnitt (4120, 5140a) und der vierte Verbindungsabschnitt (4130, 5140b) jeweils eine Laufschiene sind; und wobei die vorstehenden Stege entsprechend in die Gleitschienen eingeschoben sind, und die Positionen der vorstehenden Stege relativ zu den Gleitbahnen den Abstand zwischen dem ersten Körper und dem zweiten Körper bestimmt.

5. Das Ventilator-Haltemodul (2000) nach Anspruch 4, ferner umfassend eine Mehrzahl von Befestigungsteilen (2400) und ein auf jedem der vorspringenden Stege geformten Befestigungsloch (4152, 4162), wobei jede Gleitschiene eine Öffnungsrinne (4122, 4132) definiert und die Befestigungsteile (2400) jeweils durch die Öffnungrinnen (4122, 4132) gehen und entsprechend in die Befestigungslöcher (4152, 4162) einrasten.

6. Das Ventilator-Haltemodul (2000) nach Anspruch 4, wobei jeder der vorspringenden Stege eine Vielzahl von Öffnungen (5122) definiert, und ein Ende jeder der Gleitschienen einen Verriegelungshaken (5142) beinhaltet, und jeder der Verriegelungshaken (5142) entsprechend an einer der Vielzahl der Öffnung (5122) der vorspringenden Stege befestigt ist.

## Revendications

1. Un module de support de ventilateur (2000) pour soutenir un ventilateur (2200), le module de support de ventilateur (2000) étant **caractérisé en ce qu'**il comprend :
un premier support de ventilateur (2100a, 3100A), comprenant un premier corps (2110, 3110), une première partie de raccordement (2120, 3120) et une seconde partie de raccordement (2130, 3130), la première partie de raccordement (2120, 3120) et la seconde partie de raccordement (2130, 3130) étant disposées sur des côtés opposés du premier corps (2110, 3110) et étant parallèle l'une à l'autre; et
un second support de ventilateur (2100b, 3100b), comprenant un second corps (2140, 3140), une troisième partie de raccordement (2150, 3150) et une quatrième partie de raccordement (2160, 3160), la troisième partie de raccordement (2150, 3150) et la quatrième partie de raccordement (2160, 3160) étant disposées sur des côtés opposés du second corps (2140, 3140) et étant parallèle l'une à l'autre,
où la première partie de raccordement (2120, 3120) et la troisième partie de raccordement (2150, 3150) sont raccordées, la seconde partie de raccordement (2130, 3130) et la quatrième partie de raccordement (2160, 3160) sont raccordées, et le ventilateur (2200) est soutenu entre la première partie de raccordement (2120, 3120), la seconde partie de raccordement (2130, 3130), la troisième section de raccordement (2150, 3150), et la quatrième partie de raccordement (2160, 3160), où la première partie de raccordement (2120, 3120) et la quatrième partie de raccordement (2160, 3160) sont respectivement une bande en saillie, la seconde partie de raccordement (2130, 3130) et la troisième partie de raccordement (2150, 3150) sont respectivement un guide de coulissement, les bandes en saillies sont disposées de façon coulissante sur les guides de coulissement de façon correspondante, et les emplacements des bandes saillies aux guides de coulissement déterminent la distance entre le premier corps (2110, 3110) et le seconde corps (2140, 3140).

2. Le module de support de ventilateur (2000) de la revendication 1, comprenant en outre une pluralité de pièces de fixation (2400), et chaque bande en saillie définit un trou de fixation (2122, 2162), et chaque guide de coulissement définit un creux d'ouverture (2132, 2152), où les pièces de fixation (2400) passent respectivement à travers les creux d'ouverture (2132, 2152) et se verrouillent de manière correspondante dans les trous de fixation (2122, 2162).

3. Le module de support de ventilateur (2000) de la revendication 1, où une pluralité d'ouvertures (3122, 3162) est formée sur chacune des bandes en saillie, et une extrémité du chacun guide de coulissement comprend un crochet de verrouillage (3152), et chacun des crochets de verrouillage (3152) est fixé de façon correspondante à l'une des ouvertures (3122, 3162) des bandes en saillie.

4. Un module de support de ventilateur (2000) pour soutenir un ventilateur (2200), le module de support de ventilateur (2000) étant **caractérisé en ce qu'**il comprend :
le premier support de ventilateur (4100b, 5100a), comprenant un premier corps (5110), une première partie de raccordement (4150, 5120a) et une seconde partie de raccordement (4160, 5120b), la première partie de raccordement (4150, 5120a) et la seconde partie de raccordement (4160, 5120b) étant disposées sur des côtés opposés du premier corps (5110) et étant parallèle l'une à l'autre ; et
un second support de ventilateur (4100a, 5100b), comprenant un second corps (5130), une troisième partie de raccordement (4120, 5140a) et une quatrième partie de raccordement (4130, 5140b), la troisième partie de raccordement (4120, 5140a) et la quatrième partie de raccordement (4130, 5140b) étant disposées sur des côtés opposés du second corps (5130) et étant parallèle l'une à l'autre,
où la première partie de raccordement (4150, 5120a) et la troisième partie de raccordement (4120, 5140a) sont raccordées, la seconde partie de raccordement (4160, 5120b) et la quatrième partie de raccordement (4130, 5140b) sont raccordées, et le ventilateur (2200) est soutenu entre la première partie de raccordement (4150, 5120a), la seconde partie de raccordement (4160, 5120b), la troisième partie de raccordement (4120, 5140a), et la quatrième partie de raccordement (4130, 5140b), où la première partie de raccordement (4150, 5120a) et la seconde partie de raccordement (4160, 5120b) sont respectivement une bande en saille, et la troisième partie de raccordement (4120, 5140a) et la quatrième partie de raccordement (4130, 5140b) sont respectivement un guide de coulissement, et les bandes en saille sont insérées de façon correspondant dans les guides de coulissement, et les emplacements des bandes en saille aux guides de coulissement déterminent la distance entre le premier corps et le second corps.

5. Le module de support de ventilateur (2000) de la revendication 4, comprenant en outre une pluralité de pièces de fixation (2400) et un trou de fixation (4152, 4162) formés sur chacun des bandes en saille, où chaque guide de coulissement définit un creux d'ouverture (4122, 4132), et les pièces de fixation (2400) passent respectivement à travers les creux d'ouverture (4122, 4132) et se verrouillent de façon correspondante dans les trous de fixation (4152, 4162).

6. Le module de support de ventilateur (2000) de la revendication 4, où chacun des bandes en saille définit une pluralité des ouvertures (5122), et une extrémité du chacun guide de coulissement comprend un crochet de verrouillage (5142), et chacun des crochets de verrouillage (5142) est fixé de façon correspondante à la pluralité de l'ouverture (5122) de la pluralité des bandes en saillie.
